(19) Europäisches Patentamt
European Patent Office
Office européen des brevets

(11) EP 2 282 622 A1

(12) **EUROPEAN PATENT APPLICATION**
published in accordance with Art. 153(4) EPC

(43) Date of publication:
**09.02.2011 Bulletin 2011/06**

(21) Application number: **09754687.3**

(22) Date of filing: **26.05.2009**

(51) Int Cl.:
***H05K 3/46*** *(2006.01)* ***C08G 59/20*** *(2006.01)*
***C08L 63/00*** *(2006.01)* ***C08L 79/08*** *(2006.01)*
***H05K 1/03*** *(2006.01)* ***H05K 3/38*** *(2006.01)*

(86) International application number:
**PCT/JP2009/059591**

(87) International publication number:
**WO 2009/145179 (03.12.2009 Gazette 2009/49)**

(84) Designated Contracting States:
**AT BE BG CH CY CZ DE DK EE ES FI FR GB GR HR HU IE IS IT LI LT LU LV MC MK MT NL NO PL PT RO SE SI SK TR**
Designated Extension States:
**AL BA RS**

(30) Priority: **26.05.2008 JP 2008136844**

(71) Applicant: **Mitsui Mining & Smelting Co., Ltd**
**Shinagawa-ku**
**Tokyo 141-8584 (JP)**

(72) Inventors:
- **SATO, Tetsuro**
  **Ageo-shi**
  **Saitama 362-0021 (JP)**
- **MATSUSHIMA, Toshifumi**
  **Ageo-shi**
  **Saitama 362-0021 (JP)**
- **SHIRAI, Takeshi**
  **Ageo-shi**
  **Saitama 362-0021 (JP)**

(74) Representative: **Bohmann, Armin K.**
**bohmann**
**Anwaltssozietät**
**Nymphenburger Strasse 1**
**80335 München (DE)**

(54) **RESIN COMPOSITION FOR FORMING THE ADHESIVE LAYERS OF A MULTI-LAYER FLEXIBLE PRINTED CIRCUIT BOARD**

(57) An object of the present invention is to enable formation of a resin layer which reduces the thickness of a multilayered flexible printed wiring board without causing problems in the process of multilayer forming, and is excellent in flexibility. To achieve the object, a resin compound for forming an adhesive layer of a multilayered flexible printed wiring board which is used for formation of an adhesive layer for bonding an outer layer of a printed wiring board onto a surface of an inner layer flexible printed wiring board, the resin compound is made to comprise components A (an epoxy resin composed of one or more selected from the group consisting of bisphenol epoxy resins of which epoxy equivalents are 200 or less and are liquid at room temperature), B (an epoxy resin performing high thermal resistance), C (a phosphorus-containing flame-retardant epoxy resin), D (a rubber-modified polyamide-imide resin, the resin having the property of being soluble in a solvent having a boiling point in the range of 50 to 200˚C), and E (a resin curing agent composed of one or more selected from the group consisting of biphenyl type phenol resin and a phenol aralkyl type phenol resin) and a resin-coated copper foil and the like in which the resin layer is formed by using the resin compound is used.

EP 2 282 622 A1

## Description

### Technical Field

The present invention relates to a resin compound for forming an adhesive layer of a multilayered flexible printed wiring board, a resin varnish prepared by using the resin compound, a resin-coated copper foil having a resin layer formed by using the resin varnish, a method for producing the resin-coated copper foil, and a multilayered flexible printed wiring board.

### Background Art

In recent years, the requirements for higher performance and down-sizing of electronic equipment have been escalating and a printed wiring board used for providing electronic signals is also required to be down-sized. A printed wiring board is classified roughly into a rigid printed wiring board in a plate-shape and a flexible printed wiring board having folding endurance. The rigid printed wiring board is easy in multilayer forming and has been adopted multilayer forming for down-sizing of the printed wiring board. However, in recent years, since down-sizing is required for the flexible printed wiring board as well, multilayer forming as the same with the rigid printed wiring board has been required for the flexible printed wiring board as described in Patent Document 1.

In the multilayered flexible printed wiring board disclosed in Patent Document 1, an inner layer substrate provided with a circuit pattern is bonded with another inner layer substrate or a metal foil via a bonding sheet. The object to use the bonding sheet is to make a resin layer to be a buffer layer for leveling of the unevenness caused by the inner layer circuit pattern provided on the laminate interface. As for the bonding sheet, a bonding sheet composed of a resin essentially comprising an epoxy resin or an acrylic resin has been well known. However, the resin layer formed by using the bonding sheet has a drawback that the resin layer is poor in mechanical strength, less stiffness and brittle.

Further, Patent Document 2 discloses a thermosetting adhesive sheet for flexible printed wiring boards (= bonding sheet) which shows little powder drop-off of an adhesive resin in processing and is easy in lamination. The thermosetting adhesive sheet for flexible printed wiring boards is composed of a reinforcement which is a woven or an unwoven fabric and an adhesive resin compound. In addition, the adhesive resin compound is characterized by containing (A) an epoxy resin having two or more epoxy functional groups in a molecule, (B) at least one thermoplastic resin selected from among a polyethersulfone, a polyetherimide, and a phenoxy resin, which are soluble in a common solvent with the epoxy resin (A), and (C) an epoxy resin curing agent, wherein the weight ratio of the epoxy resin (A) to the thermoplastic resin (B), A:B is from 20:80 to 70:30.

In a multilayered rigid-flexible printed wiring board disclosed in the patent document 3, a first flexible wiring board is used as a core material, and a rigid substrate is laminated to the core material via a coverlay. The multilayered rigid-flexible printed wiring board is characterized by using a flexible insulating material having an adhesion function instead of the coverlay and the adhesive-coated resin film is used for the flexible insulating material.

The multilayered rigid-flexible printed wiring board disclosed in Patent Document 3 is produced by using a raw material for a rigid printed wiring board production and a raw material for a flexible printed wiring board production in combination, i.e., a rigid substrate is laminated to the flexible printed wiring board as a core material to form a flexible portion and a rigid portion. For example, Figure 7 of Patent Document 3 also shows one example. In the multilayered rigid-flexible printed wiring board, a conductor circuit formed on both sides of the flexible printed wiring board used for the core material should be protected. In such a case, the surfaces of the core material are usually covered with a coverlay film. However, the invention disclosed in Patent Document 3 announces that the coverlay film can be omitted when the surfaces are covered with the resin layer.

As for formation of the resin layer of the adhesive-coated resin film disclosed, a halogen-free epoxy resin compound or the like disclosed in Patent Document 4 is used as a flexible resin having folding endurance. Flame retardancy is achieved by using a phosphorus-containing compound and flexibility is achieved by mixing a crosslinked rubber, a polyvinyl acetal resin, or the like in the epoxy resin. In addition, an elastomer component such as acrylonitrile-butadiene rubber (NBR), SBR, BR, IR, EPM, EPDM, CR, butyl rubber, urethane rubber, silicone rubber, polysulfide rubber, hydrogenated nitrile rubber, polyether special rubber, fluororubber, tetrafluoroethylene-propylene rubber, acrylic rubber, epichlorohydrin rubber, propylene oxide rubber, ethylene-vinyl acetate copolymer, and ethylene-acrylic rubber are recommended to use for further improvement of folding endurance.

### Documents Cited

#### Patent Documents

[Patent Document 1]
Japanese Patent Laid-Open No. 05-037153
[Patent Document 2]
Japanese Patent Laid-Open No. 2005-336287
[Patent Document 3]
Japanese Patent Laid-Open No. 2006-93647
[Patent Document 4]
Japanese Patent No. 3320670

## Summary of the Invention

### Problems to be Solved

However, the bonding sheet disclosed in the Patent Document 1 comprises an epoxy resin or an acrylic resin as an essential component and has a drawback that the resin layer formed by using the bonding sheet is poor in mechanical strength, less stiffness and brittle. Therefore, application of the resin layer to a multilayered flexible printed wiring board in which a repeated folding action may be loaded is made difficult. Further, when a bonding sheet is used, it is required to form a resin sheet itself and it limits the minimum thickness of the sheet. As a result, thickness reduction in the multilayered flexible printed wiring board was also limited as long as the bonding sheet was used.
Then, application of the resin compound disclosed in the Patent Document 2 to form a resin layer not containing reinforcement such as a woven or an unwoven fabric will be investigated. When a thermoplastic resin such as a phenoxy resin is used in combination with an epoxy resin, the resin layer after full-curing lacks flexibility and the resin layer cannot follow the expansion-shrinkage behavior of other insulating materials in multilayer formation. So, drawback appears that a crack might be generated in the resin layer or the like.
Moreover, when the adhesive-coated resin film disclosed in Patent Document 3 and the halogen-free epoxy resin compound disclosed in Patent Document 4 are intended to use as a material for forming a resin layer of a conventional multilayered flexible printed wiring board described in Patent Document 1 and Patent Document 2, the resin layer after full-curing is hard and brittle to lack flexibility and the resin layer cannot follow the expansion-shrinkage behavior of other insulating materials in multilayer formation. So, drawback appears that a crack might be generated in the resin layer or the like.
Consequently, the method for forming a resin layer which makes reduction of the thickness of a multilayered flexible printed wiring board easy without problems in the process of multilayer forming and achieves excellent flexibility has been required.

### Means to Solve the Problem

Thus, as a result of intensive research, the present inventors have acquired that the above problems can be solved by using the resin-coated copper foil for producing a multilayered flexible printed wiring board in which a resin compound described below is used for a resin-coated copper foil. Hereinafter, the present invention will be described.
A resin compound for forming an adhesive layer of a multilayered flexible printed wiring board according to the present invention:

The resin compound for forming an adhesive layer of a multilayered flexible printed wiring board according to the present invention is a resin compound used for formation of an adhesive layer for bonding an outer layer of a printed wiring board onto a surface of an inner layer flexible printed wiring board, characterized in that the resin compound comprises the following components A to E.

component A: an epoxy resin composed of one or more selected from the group consisting of a bisphenol A type epoxy resin, a bisphenol F type epoxy resin and a bisphenol AD type epoxy resin of which epoxy equivalents are 200 or less and are liquid at room temperature;
component B: an epoxy resin performing high thermal resistance;
component C: a phosphorus-containing flame-retardant epoxy resin;
component D: a rubber-modified polyamide-imide resin which has been modified with a liquid rubbery resin and is soluble in a solvent having a boiling point in the range of 50 to 200˚C; and
component E: a resin curing agent composed of one or mixture selected from the group consisting of a biphenyl type phenol resin and a phenol aralkyl type phenol resin.

A resin varnish for forming an adhesive layer of a multilayered flexible printed wiring board according to the present invention:

The resin varnish for forming an adhesive layer of a multilayered flexible printed wiring board according to the present invention is prepared by mixing a solvent and the resin compound described above and a resin content of the resin varnish is made to be in the range of 30 to 70% by weight and it enables a semi-cured resin film formed by using the resin varnish to have a resin flow in the range of 1 to 30% when measured according to MIL-P-13949G in MIL specifications and standards.

A resin-coated copper foil for producing a multilayered flexible printed wiring board according to the present invention:

The resin-coated copper foil for producing a multilayered flexible printed wiring board according to the present invention is a resin-coated copper foil provided with a resin layer on a surface of the copper foil and characterized in that the resin layer is provided by using a resin compound for forming an adhesive layer of a multilayered flexible printed wiring board described above.

Fatigue endurance of the resin-coated copper foil according to the present invention can be further improved by providing an auxiliary resin layer between the copper foil and the semi-cured resin layer before providing the semi-cured resin layer. The auxiliary resin layer can be composed of one or mixture of resins selected from the group consisting of a polyimide resin, a polyamide resin, a polyether sulfone resin, a phenoxy resin, an aramid resin, and a polyvinyl acetal resin.

A method for producing a resin-coated copper foil used for producing a multilayered flexible printed wiring board according to the present invention:

A method for producing a resin-coated copper foil used for producing a multilayered flexible printed wiring board according to the present invention is characterized in comprising preparing of a resin varnish used for forming a resin layer according to the following steps (a) and (b), coating of the resin varnish on a surface of a copper foil, and drying of the coated resin varnish to be a semi-cured resin film having a thickness of 10 to 50 $\mu$m to finish a resin-coated copper foil.

step (a): 3 to 20 parts by weight of the component A, 3 to 30 parts by weight of the component B, 5 to 50 parts by weight of the component C, 10 to 40 parts by weight of the component D, 20 to 35 parts by weight of the component E, and 0 to 7 parts by weight of the component F are mixed to make up the resin compound containing a phosphorus atom derived from the component C in the range of 0.5 to 3.0% by weight against to 100% by weight of the resin compound; and
step (b): the resin compound is dissolved in an organic solvent to make a resin content of the resin varnish to be 30 to 70% by weight.

A multilayered flexible printed wiring board according to the present invention:

A multilayered flexible printed wiring board according to the present invention is characterized in that the multilayered flexible printed wiring board is obtained by using a resin compound for forming an adhesive layer of a multilayered flexible printed wiring board described above.

Advantages of the Invention

The resin compound for forming an adhesive layer of a multilayered flexible printed wiring board according to the present invention makes providing of a high quality multilayered flexible printed wiring board possible, because when the resin compound is made to be a resin varnish to be used for forming a resin layer to constitute an insulating layer of a multilayered flexible printed wiring board in the production process, a resin layer after full-curing shows excellent flexibility. In addition, the resin-coated copper foil according to the present invention is produced by using the resin compound and the resin varnish described above. Further, using of the resin-coated copper foil can reduce the thickness of the resin layer and suppress problems caused by poor flexibility of the full-cured resin layer in the multilayer forming process when compared with the case where a resin sheet such as a bonding sheet is used. Therefore, the thickness of an interlayer insulating layer of a multilayered flexible printed wiring board can be reduced, and a high quality multilayered flexible printed wiring board can be provided.

Embodiment of the Invention

Hereinafter, the embodiments of the present invention will be described for each item.

<The embodiments of a resin compound for forming an adhesive layer of a multilayered flexible printed wiring board>

The resin compound for forming an adhesive layer of a multilayered flexible printed wiring board according to the present invention is a resin compound used for forming an adhesive layer to bond an outer layer printed wiring board to a surface of an inner layer flexible printed wiring board used as an inner layer substrate. For example, a double sided printed wiring board composed of a polyimide resin film as the substrate on which circuits are provided on both sides and the electrical connections between the circuits on both sides are achieved by a via hole and the like when required can be used as an inner layer flexible printed wiring board. Then, an outer conductor layer is provided on both sides of the inner layer flexible printed wiring board via an adhesive layer. Subsequently, the outer conductor layer provided at an outer layer is etched to form an outer layer circuit. In such a manner, when an adhesive layer is provided on both sides or one side of the inner layer flexible printed wiring board followed by placing a prepreg and a metal foil such as a copper foil in this order on the adhesive layer, so-called four-layer copper clad laminate is obtained after hot pressing. After etching the outer conductor layer, a multilayered flexible printed wiring board is obtained. On the other hand, when the outer conductor layer is provided on both sides or one side of the inner layer flexible printed wiring board by using a resin-coated copper foil, so-called four-layer copper clad laminate is obtained after hot pressing. After etching the outer conductor layer, a multilayered flexible printed wiring board is obtained. Even the above printed wiring boards may be classified to be "multilayered rigid-flexible printed wiring board" for the former and "multilayered flexible printed wiring board" for the latter, but both types may generally be exist in a mixed state. However, the multilayered flexible printed wiring board described in the present invention is included in the latter concept. Further, the concept shall include a printed wiring board having four layers or more illustrated herein.

Thus, the resin layer of the resin-coated copper foil is made to be constituted with a resin compound characterized in that the resin compound includes components A to E described below as a basic component. Hereinafter, each component will be described.

The component A is an epoxy resin composed of one or more selected from the group consisting of a bisphenol A type epoxy resin, a bisphenol F type epoxy resin and a bisphenol AD type epoxy resin of which epoxy equivalents are 200 or less and are liquid at room temperature. Here, the reason a bisphenol epoxy resin is selected and used is that a bisphenol epoxy resin has good affinity with the component D (rubber-modified polyamide-imide resin) described below and makes a semi-cured resin flexible. The epoxy equivalent exceeding 200 is not preferable because the resin may be semi-solid at room temperature and reduce the flexibility in a semi-cured state. Further, the bisphenol epoxy resin described above may be used alone or as a mixture of two or more thereof. Moreover, when a bisphenol epoxy resin is used as a mixture of two or more thereof, the mixing ratio is not particularly limited.

The blending ratio of the epoxy resin, component A is preferable to be 3 to 20 parts by weight against to 100 parts by weight of the resin compound. When the blending ratio of the epoxy resin is less than 3 parts by weight, the resin compound may be poor in thermosetting properties to make not only performance as a binder to an inner layer flexible printed wiring board poor but also the adhesion to a copper foil as a resin-coated copper foil may be made poor. On the other hand, blending ratio of the epoxy resin exceeding 20 parts by weight is not preferable because the viscosity of a resin varnish prepared by using the resin compound may be increased due to the balance among the epoxy resin and other resin components to make forming of a resin film having a uniform thickness on a copper foil surface when a resin-coated copper foil is produced difficult. Moreover, when the blending ratio of the component D (rubber-modified polyamide-imide resin) described below is considered, toughness in a resin layer after full-curing may be made poor.

The component B is a so-called "an epoxy resin performing high thermal resistance" having high glass transition temperature (Tg). The "epoxy resin performing high thermal resistance" described herein is preferably a polyfunctional epoxy resin such as a novolac type epoxy resin, a cresol novolac type epoxy resin, a phenol novolac type epoxy resin, and a naphthalene type epoxy resin. The component B is preferably used in a blending ratio of 3 to 30 parts by weight against to 100 parts by weight of the resin compound. When the blending ratio of the component B is less than 3 parts by weight, the resin compound can hardly be a high Tg compound. On the other hand, when the blending ratio of component B exceeds 30 parts by weight, the resin after full-curing may be brittle to fully lose flexibility. So, it is not preferable for use in the flexible printed wiring board application. More preferably, the component B can be used in the range of 10 to 20 parts by weight to stably achieve both high Tg of the resin compound and good flexibility of the resin after full-curing.

The component C is a phosphorus-containing flame-retardant epoxy resin, i.e., a so-called halogen free flame-retardant epoxy resin. The phosphorus-containing flame-retardant epoxy resin is a generic name for the epoxy resin

containing phosphorus in the epoxy skeleton. Any phosphorus-containing flame-retardant epoxy resin can be used as long as the phosphorus atom content of the resin compound according to the present application can be made in the range of 0.5 to 3.0% in terms of the phosphorus atom derived from the component C against to 100% by weight of the resin compound. However, it is preferable to use a phosphorus-containing flame-retardant epoxy resin having two or more epoxy functional groups in the molecule obtained as a derivative from 9,10-dihydro-9-oxa-10-phosphaphenanthrene-10-oxide because it is excellent in both the quality stability of the resin in a semi-cured state and flame-retardancy. For reference, the structural formula of 9,10-dihydro-9-oxa-10-phosphaphenanthrene-10-oxide is represented by Formula 1.

[Formula 1]

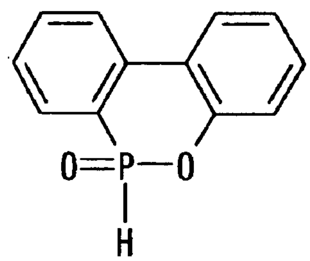

Specifically, one of the phosphorus-containing flame-retardant epoxy resin obtained as a derivative from 9,10-dihydro-9-oxa-10-phosphaphenanthrene-10-oxide is represented by Formula 2. Advantage is that both the quality stability of the resin in a semi-cured state and flame-retardancy are excellent.

[Formula 2]

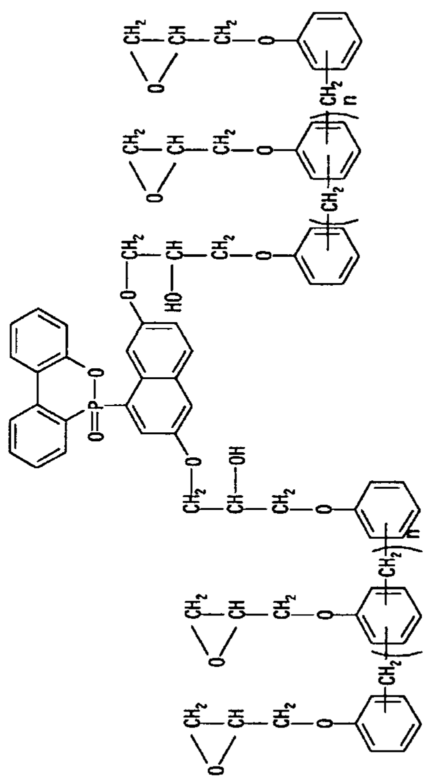

Further, a compound having the structural formula represented by Formula 3 shown below is also preferable as the phosphorus-containing flame-retardant epoxy resin of the component C. Similar to the phosphorus-containing flame-retardant epoxy resin represented by Formula 2, the compound represented by Formula 3 is preferable. It is because the compound is excellent in both quality stability of the semi-cured resin and providing of an excellent flame-retardancy.

[Formula 3]

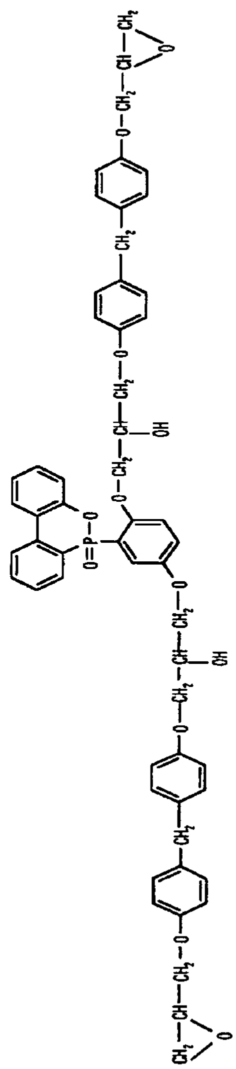

Furthermore, a compound having the structural formula represented by Formula 4 shown below is also preferable as the phosphorus-containing flame-retardant epoxy resin of the component C. Similar to the phosphorus-containing flame-retardant epoxy resin represented by Formulas 2 and 3, the compound represented by Formula 4 is preferable. It is because that the resin compound is also excellent in both the quality stability of the resin in a semi-cured state and flame-retardancy.

[Formula 4]

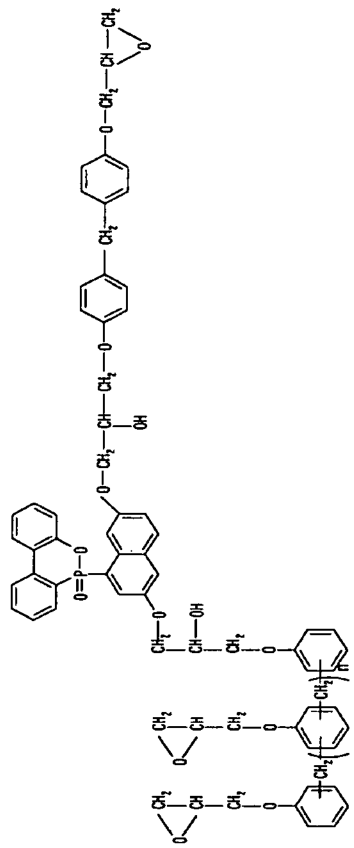

As for the epoxy resin obtained as a derivative of 9,10-dihydro-9-oxa-10-phosphaphenanthrene-10-oxide able to be exemplified is a phosphorus-containing flame-retardant epoxy resin which is obtained by making 9,10-dihydro-9-oxa-10-phosphaphenanthrene-10-oxide react with naphthoquinone or hydroquinone first to form a compound represented by Formula 5 (HCA-NQ) or Formula 6 (HCA-HQ) shown below and then the OH groups are made to react with an epoxy functional group included in a epoxy resin.

[Formula 5]

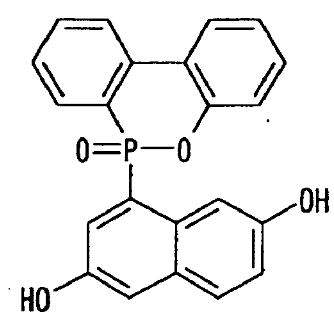

[Formula 6]

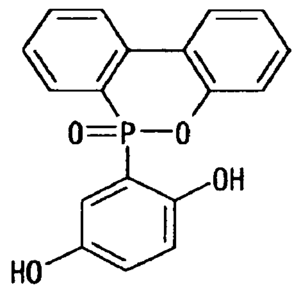

Here, the resin compound in which a phosphorus-containing flame-retardant epoxy resin is contained, the phosphorus-containing flame-retardant epoxy resin as a component C may be used alone or as a mixture of two or more thereof. However, blending ratio of the phosphorus-containing flame-retardant epoxy resin is preferable to make the phosphorus atom derived from the component C in the range of 0.5 to 3.0% by weight against to 100% by weight of the resin compound, with consideration of the total blending ratio of the phosphorus-containing flame-retardant epoxy resin as a component C. Because the phosphorus-containing flame-retardant epoxy resin contains different amount of the phosphorus atom in the epoxy resin structure depending on its formula. Therefore, the content of phosphorus atoms can be specified instead of the blending ratio of the component C described above. However, blending ratio of the component C is generally made to be in the range of 5 to 50 parts by weight against to 100 parts by weight of the resin compound. So, when the blending ratio of the component C is less than 5 parts by weight, the phosphorus atom derived from the component C hardly satisfy an blending ratio of 0.5% by weight or more when the blending ratio of other resin components is considered and flame retardancy cannot be achieved. On the other hand, when the blending ratio of the component C exceeds 50 parts by weight, effect for improvement of the flame-retardancy may be saturated and the resin layer after full-curing might be made brittle. So, it is not preferable.

The "high Tg" and "flexibility" of the full-cured resin are the trade-off properties in general. However, in the phosphorus-containing flame-retardant epoxy resins, some resins contribute to the improvement in the flexibility of the resin after full-curing, and some other resins contribute to make the Tg high. Therefore, it is recommended to blend "a phosphorus-containing flame-retardant epoxy resin which contributes to high Tg" and "a phosphorus-containing flame-retardant epoxy resin which contributes to improvement of flexibility" in well balance to obtain a resin compound suitable for the flexible printed wiring board application rather than using one type of phosphorus-containing flame-retardant epoxy resin.

The component D is a rubber-modified polyamide-imide resin which has been modified with a liquid rubbery resin and is soluble in a solvent having a boiling point in the range of 50 to 200˚C. The rubber-modified polyamide-imide resin is obtained by reaction between a polyimide-amide resin and a rubbery resin. The reason why rubber-modification of polyamide-imide resin with the rubbery resin is performed is to improve the flexibility of the polyamide-imide resin. That is, some acid functional group (such as cyclohexanedicarboxylic acid) included in the polyamide-imide resin structure is made to replace by a rubber component in the reaction with the rubbery resin. A concept of the rubbery resins described here includes natural rubber and synthetic rubber. Examples of the synthetic rubber include styrene butadiene rubber, butadiene rubber, butyl rubber, and ethylene-propylene rubber. It is preferable to use a synthetic rubber having heat resistance such as nitrile rubber, chloroprene rubber, silicon rubber, and urethane rubber, from the viewpoint of ensuring heat resistance. Such a rubbery resin is preferable to have various functional groups at the both ends thereof in order to make reaction with a polyamide-imide resin to be a copolymer easy. In particular, CTBN (carboxy-terminated butadiene nitrile) having a carboxyl group is preferable to use. Note that the above rubbery resins may be copolymerized alone or in combination. Further, when a rubbery resins are used, it is preferable to use a rubbery resin having a number average molecular weight of 1000 or more from the viewpoint of stabilization of the flexibility.

When the polymerization of rubber-modified polyamide-imide resin is carried out, a solvent used for dissolving the polyamide-imide resin and the rubbery resin is preferably selected from one or mixture of dimethylformamide, dimethylacetamide, N-methyl-2-pyrrolidone, dimethyl sulfoxide, nitromethane, nitroethane, tetrahydrofuran, cyclohexanone, methyl ethyl ketone, acetonitrile, and γ-butyrolactone. Next,
to generate a polymerization reaction, it is preferable to employ a polymerization temperature in the range of 80 to 200˚C. When a solvent having a boiling point over 200˚C is used for
the polymerization, the solvent is recommended to be replaced with a solvent having a boiling point in the range of 50 to 200˚C depending on applications.

Here, examples of the solvent having a boiling point in the range of 50 to 200˚C include one single solvent and

mixture selected from the group consisting of methyl ethyl ketone, dimethylacetamide, and dimethylformamide. When the boiling point of the solvent is less than 50˚C, the vaporization of the solvent by heating may be great to make preparation of a good semi-cured state difficult when a resin varnish is made to be a semi-cured resin. On the other hand, when the boiling point of the solvent exceeds 200˚C, bubbles tend to be trapped when a resin varnish is made to be a semi-cured resin to make preparation of a good semi-cured resin layer hard.

In the rubber-modified polyamide-imide resin used in the resin compound according to the present invention, the contained ratio of the copolymerized rubber component is preferable to be 0.8% by weight or more against to 100% by weight of the rubber-modified polyamide-imide resin. When the contained ratio of the copolymerized rubber component is less than 0.8% by weight, the resulting rubber-modified polyamide-imide resin will provide poor flexibility when full-curing a resin layer formed by using the resin compound according to the present invention, and will reduce the adhesion to a copper foil as well. So, it is not preferable. The contained ratio of the copolymerized rubber component is more preferable to be 3% by weight or more, further preferable to be 5% by weight or more. Based upon experiences, there is no particular problem when the ratio to be added of the rubber component exceeds 40% by weight. However, the improvement effect of the flexibility on the resin layer after full-curing is saturated and is made to be just waste of resources. So, it is not preferable.

One of the properties required for the rubber-modified polyamide-imide resin is solubility in a solvent. It is because when the resin is not soluble in a solvent, preparation of a resin varnish is made difficult. The rubber-modified polyamide-imide resin is used in a blending ratio of 10 to 40 parts by weight against to 100 parts by weight of the resin compound. When the blending ratio of the rubber-modified polyamide-imide resin is less than 10 parts by weight, it is difficult to improve the flexibility of the resin layer after full-curing; the resin layer is made brittle; and micro cracks tend to be generated in the resin layer after full-curing. On the other hand, when the rubber-modified polyamide-imide resin is contained in a blending ratio exceeding 40 parts by weight, no particular problem may exist. However, the flexibility of the resin layer after full-curing will not be further improved, and the resin after full-curing may not achieve higher Tg. Therefore, with consideration on economy, it can be said that 40 parts by weight may be the upper limit.

Next, a resin curing agent as a component E will be described below. As for the curing agent described here, one or mixture selected from the group consisting of a biphenyl type phenol resin and a phenol aralkyl type phenol resin can be used. In general, the blending ratio of the resin curing agent to be contained is estimated from the reaction equivalent to the resin to be cured. So, particular quantitative limitation may not be specified. However, a blending ratio of the resin curing agent in the range from 20 to 35 parts by weight against to 100 parts by weight of the resin compound is preferable in the resin compound according to the present invention. When the blending ratio of the component E is less than 20 parts by weight in the resin compound, sufficient full-curing may hardly be achieved, and flexibility in a resin after full-curing may hardly be obtained also. On the other hand, when the blending ratio of the component E exceeds 35 parts by weight, the moisture absorption resistance properties of the resin layer after full-curing tends to be poor. So, it is not preferable.

A phosphorus-containing flame retardant as a component F will be described below. The phosphorus-containing flame retardant is an optional additive component which does not required to contribute the curing reaction of resin, and it is used just for greatly improving flame retardancy. As for such a phosphorus-containing flame retardant, a phosphazene compound as a halogen free flame retardant is preferable to be used. Therefore, the component F is blended in the range of 0 to 7 parts by weight. Here, "0 parts by weight" is described to clarify that the component F may not necessarily be used and is an optional additive component. On the other hand, even if the component F exceeds 7 parts by weight, great improvement in flame retardancy may not be achieved.

<Embodiment of a resin varnish for forming an adhesive layer of a multilayered flexible printed wiring board according to the present invention>

A resin varnish for forming an adhesive layer of a multilayered flexible printed wiring board according to the present invention:

The resin varnish for forming an adhesive layer of a multilayered flexible printed wiring board according to the present invention is made a resin content of the resin varnish to be in the range of 30 to 70% by weight and it enables a semi-cured resin film formed by using the resin varnish to have a resin flow in the range of 1 to 30% when measured according to MIL-P-13949G in MIL specifications and standards. As for the solvent, it is preferable to use one or mixture of a solvent selected from the group consisting of methyl ethyl ketone, dimethylacetamide, and dimethylformamide, the solvents having a boiling point in the range of 50 to 200˚C described above. As described above, it is to obtain a good semi-cured resin layer. The range of the resin content described above is the range to make control of the film thickness accurate when the varnish is coated on the surface of a copper foil. When the resin content is less than 30% by weight, the viscosity of the resulting varnish may be too low to assure the film thickness uniformity because the varnish may start to flow just after coated on the copper foil surface. On the other hand,

when the resin content exceeds 70% by weight, the viscosity may be too high to make formation of a thin film on the copper foil surface difficult.

Further, the resin varnish is preferable to be able to make a semi-cured resin film formed by using the resin varnish have a resin flow in the range of 1 to 30% when measured according to MIL-P-13949G in MIL specifications and standards. When the resin flow is less than 1%, air voids may be generated at the uneven portion composed of the inner layer circuits on the surface of the inner layer substrate. So it is not preferable. On the other hand, when the resin flow exceeds 30%, the resin flow may be too large to make thickness of the insulating layer formed by using the resin layer of a resin-coated copper foil uneven. Note that, the resin flow in the present description is a value calculated by Expression 1 below after investigating weight of flowing-out resin measured as follows. Four 10 cm square specimens are cut from a resin-coated copper foil and the four specimens are bonded together to be a laminate by hot pressing with temperature of 171˚C and pressing pressure of 14 kgf/cm$^2$ for 10 minutes to make the coated resin flow out from 10 cm square followed by cutting and weighing of the flowing-out resin.
$$\text{Resin flow (\%)} = \frac{\text{Flowing-out resin weight}}{\text{(Laminate weight)} - \text{(Copper foil weight)}} \times 100$$

<Embodiment of a resin-coated copper foil for producing a multilayered flexible printed wiring board according to the present invention>

The resin-coated copper foil for producing a multilayered flexible printed wiring board according to the present invention is that a resin layer is provided on a surface of the copper foil. In addition, the resin layer is formed by using the resin compound for forming an adhesive layer of a multilayered flexible printed wiring board described above.
As for the copper foil, any production method including an electrolytic method and a rolling method can be used. The thickness of the copper foil is also not particularly limited. The roughening treatment may be or may not be subjected on the surface where a resin layer is formed. The roughening treatment will increase the adhesion between the copper foil and the resin layer. On the other hand, without roughening treatment, the surface may be flat and it enables improving of the formability of a fine pitch circuit. Further, the surface of the copper foil may be subjected to rust-proofing treatment. As for the rust-proofing treatment, popular inorganic rust-proofing using zinc, a zinc alloy and the like, or organic rust-proofing forming an organic monomolecular coating of benzimidazole, triazole, and the like are applicable. Further, the surface of the copper foil on which a resin layer is formed is preferably provided with a silane coupling agent treatment layer.
The silane coupling agent treatment layer is an auxiliary layer which performs wettability improvement especially for the copper foil surface which has not been subjected to roughening treatment to a resin layer and improve the adhesion after pressing to a substrate resin. For example, the surface of the copper foil can be subjected to rust-proofing treatment without roughening treatment and then subjected to silane coupling agent treatment using various silane coupling agents such as an epoxy-functional silane coupling agent, an olefin-functional silane, an acrylic-functional silane, an amino-functional silane coupling agent, or a mercapto-functional silane coupling agent. When a suitable silane coupling agent depending on applications is selected and used, a peel strength exceeding 0.8 kgf/cm can be achieved.
Here, a silane coupling agent which can be used will be more specifically shown below. The silane coupling agents may be selected from among that mainly used for treating of glass cloth for prepreg for printed wiring boards. They are vinyltrimethoxysilane, vinylphenyltrimethoxysilane, γ-methacryloxypropyltrimethoxysilane, γ-glycidoxypropyltrimethoxysilane, 4-glycidylbutyltrimethoxysilane, γ-aminopropyltriethoxysilane, N-β(aminoethyl)γ-aminopropyltrimethoxysilane, N-3-(4-(3-aminopropoxy)butoxy)propyl-3-aminopropyltrimethoxysilane, imidazole silane, triazine silane, and γ-mercaptopropyltrimethoxysilane.
The method for providing the silane coupling agent layer is not particularly limited to, but popular methods including dipping, showering, and spraying are applicable. Any method in which a solution containing a silane coupling agent can be uniformly brought into contact with the copper foil and adsorb a silane coupling agent thereon can be used in accordance with a process design. These silane coupling agents are dissolved in water as a solvent at a content of 0.5 to 10 g/l and used at room temperature. The silane coupling agent is combined with an OH group exposed at the surface of the copper foil to form a film, and even if a solution with high concentration is used, the effect may not be greatly increased. Therefore, the concentration of the silane coupling agent solution should be essentially determined

depending on the processing speed of the process or the like. However, when the concentration is made to be less than 0.5 g/l, the adsorption rate of a silane coupling agent may be made slow. So, it is not economical in a general commercial production, and the adsorption may be not uniform also. Further, even when the concentration is made to be over 10 g/l, the adsorption rate will not be increased, resulting in uneconomical operation.

In the resin-coated copper foil described above, an auxiliary resin layer may be provided between a copper foil and a semi-cured resin layer. As for the auxiliary resin layer, it can be composed of one or mixture of resins selected from the group consisting of a polyimide resin, a polyamide resin, a polyether sulfone resin, a phenoxy resin, an aramid resin, and a polyvinyl acetal resin. The auxiliary resin layer is provided before forming the semi-cured resin layer. When the two-layer structure composed of such an auxiliary resin layer and a semi-cured resin layer is employed, the resin-coated copper foil can be further improved in the flexibility and can be suitable for the multilayered flexible printed wiring board application. The auxiliary resin layer can be provided by a method so-called a casting method. More specifically, the auxiliary resin layer can be formed by applying a resin varnish for forming a polyimide resin, a polyamide resin, or a mixed resin of these two resins to a copper foil surface, removing part of a solvent in a drying process, and further removing the solvent in a high-temperature drying process followed by dehydrating condensation reaction. The thickness of the resulting auxiliary resin layer is preferable to be 10 μm or less. When the thickness exceeds 10 μm, the total thickness may be increased in the case where the auxiliary resin layer is used in combination with the semi-cured resin layer described in the present invention. Consequently, it makes reduction of the total thickness hard when processed into a multilayered flexible printed wiring board. In addition, the resin-coated copper foil tends to show warp referred to as curl in the heating process for finishing the semi-cured resin layer. Therefore, the thickness exceeding 10 μm is not preferable.

<Embodiment of a method for producing a resin-coated copper foil according to the present invention>

A method for producing a resin-coated copper foil according to the present invention prepares a resin varnish according to the following step (a) first. Then, the resin varnish is coated on a surface of a copper foil and the coated resin varnish is dried to be a resin-coated copper foil provided with a semi-cured resin film having a thickness of 10 to 50 μm. Here, when the thickness of the semi-cured resin film is less than 10 μm, the film may fail to cover the surface of the copper foil uniformly, and a local deviation in adhesion to the substrate tends to occur in the common surface of a printed wiring board. On the other hand, when the thickness of the semi-cured resin film exceeds 50 μm, the resulting resin layer may be too thick to make the flexibility of a multilayered flexible printed wiring board poor, and a local deviation in adhesion to the substrate tends to occur in the common surface of the printed wiring board.

Step (a): 3 to 20 parts by weight of the component A, 3 to 30 parts by weight of the component B, 5 to 50 parts by weight of the component C, 10 to 40 parts by weight of the component D, 20 to 35 parts by weight of the component E, and 0 to 7 parts by weight of the component F are mixed to make up the resin compound containing a phosphorus atom derived from the component C in the range of 0.5 to 3.0% by weight. Since explanation on each component and blending ratio has been described, description in detail will be omitted. Note that the order of mixing, mixing temperature, mixing procedure, mixing equipment, and the like of these components are not particularly limited.

Step (b): The resin compound is dissolved in an organic solvent to obtain a resin varnish. The organic solvent used has a boiling point in the range of 50 to 200˚C as described above, and it is preferable to use one solvent alone or a solvent mixture selected from the group consisting of methyl ethyl ketone, dimethylacetamide, and dimethylformamide. The reason is the same as described above. The resin content of the resin varnish is made to be 30 to 70% by weight. The reason why the range of the resin content has been determined is already described above. Note that any kind of a solvent other than those specifically mentioned here may be applicable if the solvent can dissolve all the resin components used in the present invention.

When the resin varnish prepared in the manner described above is coated on one side of the copper foil, the coating method is not particularly limited. However, when the target thickness provided with good accuracy is considered, a coating method and coating equipment should be suitably selected and used depending on the film thickness to be formed. Further, in the drying after forming a resin film on the surface of the copper foil, a suitable heating condition under which the film is made to be a semi-cured state should be employed depending on the property of a resin varnish.

A multilayered flexible printed wiring board according to the present invention:

A multilayered flexible printed wiring board according to the present invention is obtained by using a resin compound for forming an adhesive layer of the multilayered flexible printed wiring board described above. Namely, a resin compound according to the present invention is made to be a resin varnish, and the resin varnish is used to produce a resin-coated copper foil. Then, the resin-coated copper foil is used to produce a multilayered flexible printed wiring board. At this time, there is no particular limitation on the process for production of the multilayered flexible printed wiring board by using the resin-coated copper foil. Any popular production method can be used. Note that, the multilayered flexible printed wiring board according to the present invention is referred to as a printed wiring board

comprising a conductor layer having a circuit shape of three or more layers. Hereinafter, Examples will be described.

Example 1

At first in the descriptions on Examples, method for synthesis of two types of phosphorus-containing epoxy resins used in Examples will be exemplified.

[Synthesis of phosphorus-containing epoxy resin A]

A four-necked separable glass flask equipped with a stirrer, a thermometer, a condenser, and a nitrogen gas introducing device was charged with 324 parts by weight of 10-(2,5-dihydroxyphenyl)-10H-9-oxa-10-phosphaphenanthrene-10-oxide (HCA-HQ, manufactured by Sanko Co., Ltd.) and 300 parts by weight of ethyl cellosolve and elevated temperature to dissolve these components. Then, 680 parts by weight of YDF-170 (bisphenol F type epoxy resin manufactured by Tohto Kasei Co., Ltd.) was charged to and stirred while introducing nitrogen gas, and heated up to 120˚C to mix these components. Further, 0.3 parts by weight of a triphenylphosphine reagent was charged to and kept at 160˚C for 4 hours to make them react. Epoxy equivalent was 501 g/eq and phosphorus content was 3.1% by weight in the obtained epoxy resin.

[Synthesis of phosphorus-containing epoxy resin B]

A four-neck separable glass flask equipped with a stirrer, a thermometer, a condenser, and a nitrogen gas introducing device was charged with 324 parts by weight of 10-(2,5-dihydroxyphenyl)-10H-9-oxa-10-phosphaphenanthrene-10-oxide (HCA-HQ, manufactured by Sanko Co., Ltd.) and 300 parts by weight of ethyl cellosolve and elevated temperature to dissolve these components. Then 1080 parts by weight of YDPN-638 (phenol novolac type epoxy resin manufactured by Tohto Kasei Co., Ltd.) was charged and stirred while introducing nitrogen gas, and heated up to 120˚C to mix these components. Further, 0.3 parts by weight of a triphenylphosphine reagent was charged to and kept at 160˚C for 4 hours to make them react. Epoxy equivalent was 350 g/eq and phosphorus content was 2.2% by weight in the obtained epoxy resin.

[Preparation of a rubber-modified polyamide-imide resin]

A method disclosed in Japanese Patent Laid-Open No. 2004-152675 was employed. A four-neck flask equipped with a stirrer, a thermometer, a condenser, and a nitrogen gas introducing device was charged with 0.9 mol of trimellitic anhydride (TMA), 0.1 mol of dicarboxypoly(acrylonitrile-butadiene) rubber (Hycar CTBN1300x13: molecular weight: 3500, manufactured by Ube Industries, Ltd.), 1 mol of diphenylmethane diisocyanate (MDI), and 0.01 mol of potassium fluoride, together with N-methyl-2-pyrrolidone to make solid content of 20%. The mixture was stirred at 120˚C for 1.5 hours, then heated up to 180˚C, and further stirred for about 3 hours to synthesize a polyamide-imide resin having a rubber-modified content of 9% by weight. Logarithmic viscosity was 0.65 dl/g and glass transition temperature was 203˚C in the resulting polyamide-imide resin.

[Preparation of a resin varnish]

The resin varnish was prepared by using the phosphorus-containing epoxy resin and the rubber-modified polyamide-imide resin obtained in the synthetic methods described above. In particular, the resin varnish was prepared by using a resin compound including the resin components described in Table 1 below, making the blending ratio to be shown in Table 2 and using a mixed solvent as a solvent being prepared by mixing dimethylacetamide and methyl ethyl ketone at a ratio of 3:2 (weight ratio).

[Table 1]

| Name | Product name | Manufacturer's name |
|---|---|---|
| Liquid epoxy resin (Bis F type) | YDF-170 | Tohto Kasei Co., Ltd. |
| Epoxy resin performing high thermal resistance | YDCN-703 | Tohto Kasei Co., Ltd. |
| Phosphorus-containing epoxy resin A | Prepared by synthesis | - |
| Phosphorus-containing epoxy resin B | Prepared by synthesis | - |

(continued)

| Name | Product name | Manufacturer's name |
|---|---|---|
| Curing agent (biphenyl type phenol resin) | MEH-7851M | Meiwa Plastic Industries, Ltd. |
| Rubber-modified polyamide-imide resin | Prepared by synthesis | - |
| Phosphorus-containing flame retardant | SPB-100 | Otsuka Chemical Co., Ltd. |

[Table 2]

| | Components | Unit | Example 1 |
|---|---|---|---|
| Component A | Liquid epoxy resin (Bis F type) | Parts by weight | 5.0 |
| Component B | Epoxy resin performing high thermal resistance | | 15.0 |
| Component C | Phosphorus-containing epoxy resin A | | 31.0 |
| | Phosphorus-containing epoxy resin B | | - |
| Component D | Rubber-modified polyamide-imide resin | | 20.0 |
| Component E | Curing agent (biphenyl type phenol resin) | | 29.0 |
| Component F | Phosphorus-containing flame retardant | | - |
| Total | | | 100.0 |
| Phosphorus content | | % by weight | 0.97 |
| Resin content of resin varnish | | % by weight | 45 |

[Preparation of a resin-coated copper foil]

The resin varnish described above was coated on a bonding surface of a commercially available electro-deposited copper foil (nominal thickness 18 μm) using an edge coater to make the thickness of the resin varnish after drying 50 μm and dried under a heating condition of 150˚C × 5 minutes to evaporate the solvent, then a resin-coated copper foil was prepared.

[Evaluation of the multilayered printed wiring board] [Peel strength and solder blister resistance as received]

An inner layer substrate was prepared by forming an inner layer circuit on both sides of a commercially available copper clad laminate having a thickness of 0.4 mm composed of an electro-deposited copper foils each having a nominal thickness of 18 μm laminated on both sides of FR-4 (glass-epoxy substrate) followed by black-oxide treatment. The resin-coated copper foils were laminated on both sides of the inner layer substrate under vacuum pressing condition, heating temperature of 190˚C with pressing pressure of 40 kgf/cm$^2$ for 90 minutes to obtain a four-layered flexible copper clad laminate. The 10 mm wide straight circuit for a peel strength measurement was formed on the four-layered flexible copper clad laminate. Then, the 10 mm wide straight circuit was peeled off in the 90˚ direction to the substrate surface to measure "peel strength". Further, a test specimen for measuring solder blister resistance prepared by cutting into a size of 50 mm x 50 mm was floated on a solder bath at 260˚C to measure the "solder blister resistance as received" as the time until blistering. The peel strength was indicated by ○ for the value exceeding 1.0 kgf/cm, by Δ for the value in the range of 0.8 to 1.0 kgf/cm, and by × for the value less than 0.8 kgf/cm. Further, the solder blister resistance as received was indicated by ○ for the time 300 seconds or more, by Δ for the time in the range of 240 to 300 seconds, and by × for the time less than 240 seconds. These evaluation results are shown in Table 7 below to make the comparison with Comparative Examples easy.

[Solder blister resistance after boiling]

The copper foil layer as the outer layer of the test specimen for measuring solder blister resistance prepared by cutting into a size of 50 mm × 50 mm was removed by etching. The resulting specimen was boiled for 3 hours in de-ionized water to perform boiling treatment. Then, water was wiped out from the specimen just after boiling treatment.

The resulting sample was immersed in a 260˚C solder bath for 20 seconds to check the blistering. Specimen without blistering was indicated by ○, specimen with slight blistering was indicated by Δ and specimen with obvious blistering was indicated by X. The results are shown in Table 7 to make the comparison with Comparative Examples easy.

[Solder blister resistance after moisture absorption]

Moisture absorption was carried out on the resin-coated copper foil by keeping in an environmental test chamber at a temperature of 30˚C and a relative humidity of 65% for 15 hours. Procedures for preparation of the four-layer multilayered flexible printed wiring board was same as described above except that the moisture absorbed resin-coated copper foil was used. Then, the specimen for measuring solder blister resistance prepared by cutting from the four-layer multilayered flexible printed wiring board into a size of 50 mm × 50 mm was floated on a solder bath at 260˚C and measured the time until blistering. The results are shown in Table 7 to make the comparison with Comparative Examples easy. The specimen with the solder blister resistance after moisture absorption was indicated by ○ for the time 300 seconds or more, by Δ for the time in the range of 240 to 300 seconds, and by × for the time less than 240 seconds.

[Evaluation of glass transition temperature (Tg)]

The resin-coated copper foil prepared was pressed at a temperature of 190˚C with pressure of 40 $Kgf/cm^2$ for 90 minutes and the copper foil is removed by etching to prepare a single layer resin film having a thickness of 46 μm. Then, the single layer resin film was cut into a size of 30 mm × 5 mm specimen for measuring glass transition temperature (Tg). The glass transition temperature (Tg) was measured by using a dynamic viscoelasticity measuring device (Type SDM5600: manufactured by Seiko Instruments Inc.) as a dynamic mechanical analysis device (DMA). The specimen showing a glass transition temperature (Tg) of exceeding 150˚C was indicated as ○, the specimen showing a Tg of 140 to 150˚C was indicated as Δ and the specimen showing a Tg of less than 140˚C was indicated as ×. These evaluation results are shown in Table 7 below to make the comparison with Comparative Examples easy.

[Evaluation of flexibility of a resin layer after full-curing]

The resin-coated copper foil was sandwiched between fluorine resin-based heat-resistant films, and the resin layer was cured at a temperature of 190˚C with pressure of 40 $Kgf/cm^2$ for 90 minutes by using a vacuum press. Next, the copper foil layer was removed by etching from the resin-coated copper foil after finishing the curing treatment, and the resulting full-cured resin film having a thickness of 46 μm cut into a size of 15mm × 150 mm was made to be a film specimen for a folding endurance test. Then, the film for a folding endurance test was used for performing the folding endurance test by the MIT method. In the folding endurance test by the MIT method, the film for a folding endurance test was subjected to a repeated folding test by using a film folding fatigue endurance tester with a chamber (Type 549: manufactured by Toyo Seiki Seisakusho, Ltd.) as an MIT folding endurance tester under conditions of a folding radius of 0.8 mm and a load of 0.5 kgf. In Table 7 showing the results, a film specimen for a folding endurance test that has endured a number of repeated folding of 2000 times or more was indicated by ○ (acceptable) and others were unacceptable. However, an unacceptable film specimen that has endured a number of repeated folding close to 2000 times was indicated by Δ, and other unacceptable film specimen was indicated by ×. Note that one round-trip of the driving head of the MIT folding endurance tester is recorded as one time (one cycle) for counting the number of repeated folding. These evaluation results are shown in Table 7 below to make the comparison with Comparative Examples easy.

Example 2

In Example 2, the following resin varnish was prepared in the same manner as in Example 1 except that the resin compound in Example 1 was replaced by a resin compound having the blending ratio shown in Table 3 which was obtained by using the resin components described in Table 1 above, and using dimethylacetamide as a solvent.
[Table 3]

| | Components | Unit | Example 2 |
|---|---|---|---|
| Component A | Liquid epoxy resin (Bis F type) | Parts by weight | 5.0 |
| Component B | Epoxy resin performing high thermal resistance | | 5.0 |
| Component C | Phosphorus-containing epoxy resin A | | 6.0 |
| | Phosphorus-containing epoxy resin B | | 31.0 |
| Component D | Rubber-modified polyamide-imide resin | | 27.0 |
| Component E | Curing agent (biphenyl type phenol resin) | | 26.0 |
| Component F | Phosphorus-containing flame retardant | | - |
| Total | | | 100.0 |
| Phosphorus content | | % by weight | 0.87 |
| Resin content of resin varnish | | % by weight | 45 |

Then, a resin-coated copper foil was prepared in the same manner as in Example 1, and the evaluation of a multilayered printed wiring board and the evaluation of flexibility of a resin layer after curing were carried out in the same manner as in Example 1. These evaluation results are shown in Table 5 below to make the comparison with Comparative Examples easy.

Example 3

In Example 3, the following resin varnish was prepared in the same manner as in Example 1 except that the resin compound in Example 1 was replaced by a resin compound having the blending ratio shown in Table 4 which was obtained by using the resin components described in Table 1 above, and using dimethylacetamide as a solvent.

[Table 4]

| | Components | Unit | Example 3 |
|---|---|---|---|
| Component A | Liquid epoxy resin (Bis F type) | Parts by weight | 5.0 |
| Component B | Epoxy resin performing high thermal resistance | | 14.0 |
| Component C | Phosphorus-containing epoxy resin A | | - |
| | hosphorus-containing epoxy resin B | | 12.0 |
| Component D | Rubber-modified polyamide-imide resin | | 37.0 |
| Component E | Curing agent (biphenyl type phenol resin) | | 27.0 |
| Component F | Phosphorus-containing flame retardant | | 5.0 |
| Total | | | 100.0 |
| Phosphorus content | | % by weight | 1.03 |
| [0081] Resin content of resin varnish | | % by weight | 43 |

Then, a resin-coated copper foil was prepared in the same manner as in Example 1, and the evaluation of a multilayered printed wiring board and the evaluation of flexibility of a resin layer after curing were carried out in the same manner as in Example 1. These evaluation results are shown in Table 7 below to make the comparison with Comparative Examples easy.

Comparative Examples

[Comparative Example 1]

In Comparative Example 1, the curing agent in the resin compound used in Examples was replaced to a phenolic novolac resin in preparation of a resin-coated copper foil. Then, the properties described above were evaluated for comparison with those of Examples. The resin-coated copper foil used here was prepared by using a resin compound and a resin varnish shown in Table 5 below for forming of a resin layer on the bonding surface of the same copper foil used in Example 1 and was made to be the resin-coated copper foil for comparison.

[Table 5]

| | Components | Unit | Comparative Example 1 |
|---|---|---|---|
| Component A | Liquid epoxy resin (Bis F type) | Parts by weight | 6.0 |
| Component B | Epoxy resin performing high thermal resistance | | 18.0 |
| Component C | Phosphorus-containing epoxy resin A | | 36.0 |
| | Phosphorus-containing epoxy resin B | | - |
| Component D | Rubber-modified polyamide-imide resin | | 20.0 |
| Component E (substitute) | Curing agent (phenol novolac resin) | | 20.0 |
| Component F | Phosphorus-containing flame retardant | | - |
| Total | | | 100.0 |
| Phosphorus content | | % by weight | 1.11 |
| Resin content of resin varnish | | % by weight | 45 |

[Comparative Example 2]

In Comparative Example 2, the "rubber-modified polyamide-imide resin such as CTBN" in the resin compound used in Examples was replaced to a polyvinyl acetal resin (5000A manufactured by DENKI KAGAKU KOGYO K.K.) and a urethane resin (Coronate AP manufactured by Nippon Polyurethane Industry Co., Ltd.) to prepare a resin-coated copper foil. Then, the above described properties were evaluated for comparison with those of Examples. The resin-coated copper foil used here was prepared by using a resin compound and a resin varnish shown in Table 6 below for forming of a resin layer on the bonding surface of the same copper foil used in Example 1 and was made to be the resin-coated copper foil for comparison.

[Table 6]

| | Components | Unit | Comparative Example 2 |
|---|---|---|---|
| Component A | Liquid epoxy resin (Bis F type) | Parts by weight | 5.0 |
| Component B | Epoxy resin performing high thermal resistance | | 14.0 |
| Component C | Phosphorus-containing epoxy resin A | | 29.0 |
| | Phosphorus-containing epoxy resin B | | - |
| Component D | Polyvinyl acetal resin | | 18.0 |
| (substitute) | Urethane resin | | 7.0 |
| Component E | Curing agent (biphenyl type phenol resin) | | 27.0 |
| Component F | Phosphorus-containing flame retardant | | - |
| Total | | | 100.0 |

(continued)

| | Components | Unit | Comparative Example 2 |
|---|---|---|---|
| Phosphorus content | | % by weight | 0.97 |
| Resin content of resin varnish | | % by weight | 35 |

[Comparison between Examples and Comparative Examples]

The measured properties are summarized in Table 7 below to make the comparison among Examples and Comparative Examples easy.

[Table 7]

| Evaluation Items | Examples | | | Comparative Examples | |
|---|---|---|---|---|---|
| | 1 | 2 | 3 | 1 | 2 |
| Folding endurance | ○ | ○ | ○ | × | ○ |
| Resin flow | 16.7% | 8.3% | 3.7% | 12.4% | 8.5% |
| Peel strength (as received) | ○ | ○ | ○ | Δ | Δ |
| Solder blister resistance as received, 260˚C | ○ | ○ | ○ | ○ | ○ |
| Solder blister resistance after boiling, 260˚C | ○ | ○ | ○ | ○ | × |
| Solder blister resistance after moisture absorption, 260˚C, after moisture absorption | ○ | ○ | ○ | ○ | × |
| Glass transition temperature (Tg) | ○ | ○ | ○ | Δ | × |
| ○: Acceptable, Δ: Unacceptable (close to acceptable), × : Unacceptable | | | | | |

Examples and Comparative examples will be compared with reference to Table 7. First, as for the peel strength, higher values are obtained in Examples than in Comparative Examples. So, it can be understood that Examples show good adhesion to the inner layer substrate.

Next, as for the solder blister resistance as received, the difference among Examples and Comparative Examples does not exist, i.e., both show good results. However, in the solder blister resistances after boiling and moisture absorption for estimating the influences of moisture absorption for quality degradation, no great difference between Examples and Comparative Example 1 exists, but it is clear that the results obtained in Examples are better than in Comparative Example 2. That is, it is understood that it is important to contain the "rubber-modified polyamide-imide resin such as CTBN" as a component of the resin compound from the viewpoint of preventing the degradation of solder blister resistance properties after moisture absorption.

Further, as for the glass transition temperature, Tg in Examples is higher than Tg in Comparative Examples. It means that the resin compound of Examples might show excellent stability in high temperature atmosphere.

As for the folding endurance, a folding endurance of 2000 times or more was achieved by the MIT method in the resin compound of Comparative Example 2. On the other hand, in the resin compound of Comparative Example 1, the folding endurance was 100 times and is far less than a folding endurance of 2000 times or more. On the other hand, in the resin compound of Examples, a folding endurance of 2000 times or more was achieved. That is, when the resin compound of Examples are compared with the resin compound of Comparative Examples, it is clear that a greatly superior folding endurance is demonstrated in the resin compound of Examples, and better performance in other various properties are also provided in the resin compound of Examples.

Industrial Applicability

The resin compound for forming an adhesive layer of a multilayered flexible printed wiring board according to the present invention can be made to be a resin varnish and used as a resin layer for forming an insulating layer in the production process of a multilayered flexible printed wiring board. The resin layer obtained by using the resin compound has a sufficient flexibility even after full-curing. Then, the resin-coated copper foil according to the present invention can be obtained by coating a resin varnish prepared by using the resin compound on the surface of a copper foil and make

a resin layer semi-cured. A special apparatus is not required to produce the resin-coated copper foil. Therefore, existing facilities can be effectively utilized. Further, by using the resin-coated copper foil, the multilayered flexible printed wiring board can be produced by various methods, and the total weight reduction can be achieved by reduction of the substrate thickness of the resulting multilayered flexible printed wiring board.

## Claims

1. A resin compound for forming an adhesive layer of a multilayered flexible printed wiring board which is used for formation of an adhesive layer for bonding an outer layer of a printed wiring board onto a surface of an inner layer flexible printed wiring board, **characterized in that** the resin compound comprises the following components A to E:

    component A: an epoxy resin composed of one or more selected from the group consisting of a bisphenol A type epoxy resin, a bisphenol F type epoxy resin and a bisphenol AD type epoxy resin of bisphenol epoxy resins of which epoxy equivalents are 200 or less and are liquid at room temperature;
    component B: an epoxy resin performing high thermal resistance;
    component C: a phosphorus-containing flame-retardant epoxy resin;
    component D: a rubber-modified polyamide-imide resin which has been modified with a liquid rubbery resin and is soluble in a solvent having a boiling point in the range of 50 to 200˚C; and
    component E: a resin curing agent composed of one or mixture selected from the group consisting of a biphenyl type phenol resin and a phenol aralkyl type phenol resin.

2. The resin compound for forming an adhesive layer of a multilayered flexible printed wiring board according to claim 1, further comprising a component F, a phosphorus-containing flame retardant having no reactivity with an epoxy resin in addition to the components A to E.

3. The resin compound for forming an adhesive layer of a multilayered flexible printed wiring board according to claim 1 or 2, wherein the component A comprises 3 to 20 parts by weight, the component B comprises 3 to 30 parts by weight, the component C comprises 5 to 50 parts by weight, the component D comprises 10 to 40 parts by weight, the component E comprises 20 to 35 parts by weight, and the component F comprises 0 to 7 parts by weight when parts by weight of the resin compound is made to be 100; and
the resin compound contains a phosphorus atom derived from the component C in the range of 0.5 to 3.0% by weight against to 100% by weight of the resin compound.

4. The resin compound for forming an adhesive layer of a multilayered flexible printed wiring board according to any of claims 1 to 3, wherein the component D is a rubber-modified polyamide-imide resin which has been modified with a liquid rubbery resin, and is soluble in one single solvent or a solvent mixture selected from the group consisting of methyl ethyl ketone, dimethylacetamide, and dimethylformamide having a boiling point in the range of 50 to 200˚C.

5. The resin compound for forming an adhesive layer of a multilayered flexible printed wiring board according to any of claims 1 to 4, wherein the component D, the rubber-modified polyamide-imide resin is obtained through reaction between a polyamide-imide resin and a rubbery resin.

6. A resin varnish for forming an adhesive layer of a multilayered flexible printed wiring board prepared by mixing a solvent and a resin compound according to any of claims 1 to 5, **characterized in that** a resin content of the resin varnish is made to be in the range of 30 to 70% by weight and it enables a semi-cured resin film formed by using the resin varnish to have a resin flow in the range of 1 to 30% when measured according to MIL-P-13949G in MIL specifications and standards.

7. The resin-coated copper foil for producing a multilayered flexible printed wiring board as the resin-coated copper foil provided with a resin layer on a surface of the copper foil, **characterized in that** the resin layer is provided by using the resin compound for forming an adhesive layer of a multilayered flexible printed wiring board according to any of claims 1 to 5.

8. The resin-coated copper foil for producing a multilayered flexible printed wiring board according to claim 7, wherein the surface of the copper foil on which the resin layer is provided with a silane coupling agent treatment layer.

9. A method for producing a resin-coated copper foil used for producing a multilayered flexible printed wiring board

according to claims 7 or 8, the method comprises:

preparing of a resin varnish used for forming a resin layer according to the following steps (a) and (b),
coating of the resin varnish on a surface of a copper foil, and
drying of the coated resin varnish to be a semi-cured resin film having a thickness of 10 to 50 $\mu$m to finish a resin-coated copper foil, wherein
step (a): 3 to 20 parts by weight of the component A, 3 to 30 parts by weight of the component B, 5 to 50 parts by weight of the component C, 10 to 40 parts by weight of the component D, 20 to 35 parts by weight of the component E, and 0 to 7 parts by weight of the component F are mixed to make up the resin compound containing a phosphorus atom derived from the component C in the range of 0.5 to 3.0% by weight against to 100% by weight of the resin compound; and
step (b): the resin compound is dissolved in an organic solvent to make a resin content of the resin varnish to be 30 to 70% by weight.

**10.** A multilayered flexible printed wiring board which is obtained by using a resin compound for forming an adhesive layer of a multilayered flexible printed wiring board according to any of claims 1 to 5.

## INTERNATIONAL SEARCH REPORT

International application No.
PCT/JP2009/059591

A. CLASSIFICATION OF SUBJECT MATTER
H05K3/46(2006.01)i, C08G59/20(2006.01)i, C08L63/00(2006.01)i, C08L79/08 (2006.01)i, H05K1/03(2006.01)i, H05K3/38(2006.01)i

According to International Patent Classification (IPC) or to both national classification and IPC

B. FIELDS SEARCHED

Minimum documentation searched (classification system followed by classification symbols)
H05K3/46, C08G59/20, C08L63/00, C08L79/08, H05K1/03, H05K3/38

Documentation searched other than minimum documentation to the extent that such documents are included in the fields searched

| | | | |
|---|---|---|---|
| Jitsuyo Shinan Koho | 1922-1996 | Jitsuyo Shinan Toroku Koho | 1996-2009 |
| Kokai Jitsuyo Shinan Koho | 1971-2009 | Toroku Jitsuyo Shinan Koho | 1994-2009 |

Electronic data base consulted during the international search (name of data base and, where practicable, search terms used)

C. DOCUMENTS CONSIDERED TO BE RELEVANT

| Category* | Citation of document, with indication, where appropriate, of the relevant passages | Relevant to claim No. |
|---|---|---|
| A | JP 2006-265304 A (Tokai Rubber Industries, Ltd.), 05 October, 2006 (05.10.06), Par. Nos. [0009] to [0016], [0054] to [0062] (Family: none) | 1-10 |
| A | JP 2006-169481 A (Sumitomo Bakelite Co., Ltd.), 29 June, 2006 (29.06.06), Par. Nos. [0007] to [0034], [0046] to [0052] (Family: none) | 1-10 |
| A | JP 2006-70176 A (KYOCERA Chemical Corp.), 16 March, 2006 (16.03.06), Par. Nos. [0008] to [0029] (Family: none) | 1-8 |

☒ Further documents are listed in the continuation of Box C. ☐ See patent family annex.

* Special categories of cited documents:
"A" document defining the general state of the art which is not considered to be of particular relevance
"E" earlier application or patent but published on or after the international filing date
"L" document which may throw doubts on priority claim(s) or which is cited to establish the publication date of another citation or other special reason (as specified)
"O" document referring to an oral disclosure, use, exhibition or other means
"P" document published prior to the international filing date but later than the priority date claimed
"T" later document published after the international filing date or priority date and not in conflict with the application but cited to understand the principle or theory underlying the invention
"X" document of particular relevance; the claimed invention cannot be considered novel or cannot be considered to involve an inventive step when the document is taken alone
"Y" document of particular relevance; the claimed invention cannot be considered to involve an inventive step when the document is combined with one or more other such documents, such combination being obvious to a person skilled in the art
"&" document member of the same patent family

| | |
|---|---|
| Date of the actual completion of the international search<br>21 August, 2009 (21.08.09) | Date of mailing of the international search report<br>01 September, 2009 (01.09.09) |
| Name and mailing address of the ISA/<br>Japanese Patent Office<br>Facsimile No. | Authorized officer<br>Telephone No. |

Form PCT/ISA/210 (second sheet) (April 2007)

**INTERNATIONAL SEARCH REPORT**

International application No.
PCT/JP2009/059591

C (Continuation). DOCUMENTS CONSIDERED TO BE RELEVANT

| Category* | Citation of document, with indication, where appropriate, of the relevant passages | Relevant to claim No. |
|---|---|---|
| A | JP 2005-105182 A (Sumitomo Bakelite Co., Ltd.), 21 April, 2005 (21.04.05), Par. Nos. [0007] to [0014], [0021] to [0036] (Family: none) | 1-8 |
| A | JP 2003-27028 A (Shin-Etsu Chemical Co., Ltd.), 29 January, 2003 (29.01.03), Par. Nos. [0008] to [0047] (Family: none) | 1-8 |
| A | JP 2002-226818 A (Hitachi Chemical Co., Ltd.), 14 August, 2002 (14.08.02), Par. Nos. [0006] to [0016] (Family: none) | 1-8 |
| A | JP 2002-161205 A (Hitachi Chemical Co., Ltd.), 04 June, 2002 (04.06.02), Par. Nos. [0009] to [0014] (Family: none) | 1-8 |
| A | JP 2001-11421 A (Toyobo Co., Ltd.), 16 January, 2001 (16.01.01), Par. Nos. [0007] to [0028] (Family: none) | 1-8 |

Form PCT/ISA/210 (continuation of second sheet) (April 2007)

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description


- JP 5037153 A
- JP 2005336287 A
- JP 2006093647 A
- JP 3320670 B
- JP 2004152675 A